# EUROPEAN PATENT APPLICATION

(11) **EP 4 365 941 A1**
(43) Date of publication of application: **08.05.2024**
(21) Application number: 22205356.3
(22) Date of filing: 03.11.2022
(51) Int. Cl.: H01L 23/495, H01L 23/00

(54) **A LOCKING CLIP, A SEMICONDUCTOR DEVICE, AND A METHOD OF MANUFACTURING A SEMICONDUCTOR DEVICE**

(71) Applicant: Nexperia B.V., 6534 AB Nijmegen (NL)
(72) Inventor: Yandoc, Ricardo, Manchester, SK7 5BJ (GB); Milo, Dolores, Manchester (GB)
(74) Representative: Pjanovic, Ilija

(57) **Abstract**

According to a first example of the disclosure, a locking system for a semiconductor device is proposed. The locking system incorporates or comprises a locking clip and a lead frame, wherein the lead frame comprises a first lead frame surface and a second lead frame surface opposite the first lead frame surface. The locking clip comprises a first locking clip surface and a second locking clip surface opposite the first locking clip surface, and comprises a first locking means. Also, the lead frame comprises a second locking means. The first locking means are structured to align with the second locking means, such that a movement of the locking clip relative to the lead frame is possible in only one direction, and wherein the locking clip is placed on the lead frame, such that the first locking clip surface of the locking clip is in contact with the second lead frame surface of the lead frame. This configuration prevents clip swaying during assembly and maximizes the use of copper material for both clips and lead frame components while making the density of manufactured semiconductor devices higher. Additionally, the disclosure also pertains to a semiconductor device and a method for manufacturing such semiconductor device.

## Description

### TECHNICAL FIELD

The present disclosure relates to a semiconductor device wherein a specific design of a clip frame is used during the manufacturing process.

### BACKGROUND OF THE DISCLOSURE

It is known from the prior art that a clip frame may be used during a manufacturing process of semiconductor devices. Main difficulty of such process is that the clip frame must align with a lead frame and both must stay in the same position, relative to each other, during the whole process.

One solution is presented in prior art patent publication no. US2006/214290A1. A semiconductor device is provided having a single-piece clip that interlocks into a lead frame using one or more forks on the clip that mate with one or more corresponding slots in the lead frame. A semiconductor die is mounted to a pad of the lead frame and the clip couples the die to a conductive lead of the lead frame. The interlocking coupling forms a lever that allows adjustment of a position of the clip relative to a region of the semiconductor die. Interference between the clip fork and a slot corresponding to the clip fork confines the lever motion or pivoting of the clip relative to the mounted semiconductor die. The coupling between the clip fork and the slot furthermore confines motion of the clip in each of a first dimension and a second dimension relative to a position of the lead frame.

Accordingly, it is a goal of the present disclosure to prevent clip swaying during assembly and to maximize the use of copper material for both clips and lead frame while making the density of manufactured semiconductor devices higher.

### SUMMARY OF THE DISCLOSURE

According to a first example of the disclosure, a locking system for a semiconductor device is proposed. The locking system incorporates or comprises a locking clip and a lead frame, wherein the lead frame comprises a first lead frame surface and a second lead frame surface opposite the first lead frame surface. The locking clip comprises a first locking clip surface and a second locking clip surface opposite the first locking clip surface, and comprises a first locking means. Also, the lead frame comprises a second locking means. The first locking means are structured to align with the second locking means, such that a movement of the locking clip relative to the lead frame is possible in only one direction, and wherein the locking clip is placed on the lead frame, such that the first locking clip surface of the locking clip is in contact with the second lead frame surface of the lead frame. This configuration prevents clip swaying during assembly and maximizes the use of copper material for both clips and lead frame components while making the density of manufactured semiconductor devices higher.

In a further example, the movement is only possible in a direction perpendicular to the plane formed by the lead frame. In preferred examples, one of the first locking means or the second locking means is formed as at least one protrusion, preferably two protrusions and the other one of the first locking means or the second locking means is formed as a corresponding socket receiver, in particular the socket receiver is in form of a slot.

Alternatively, the slot is located on an outer edge of the locking clip or the lead frame and/or the socket receiver is in form of a groove.

The pillar or bar may extends approximately perpendicular to a plane formed by the locking clip or the lead frame.

The disclosure also pertains to a semiconductor device, which comprises a locking system according to the disclosure and also including a semiconductor die comprising a first semiconductor die surface and a second semiconductor die surface opposite the first semiconductor die surface, at least one clip comprising a first clip surface and a second clip surface opposite the first clip surface, and a mold compound, wherein the first semiconductor die surface of the semiconductor die is connected to the second lead frame surface and wherein the first clip surface of the at least one clip is connected to the second semiconductor die surface of the semiconductor die, and wherein the mold compound encapsulates the semiconductor die such that the mold compound forms an outer surface of the semiconductor device with the second locking clip surface of the locking clip, the second clip surface of the at least one clip and the first lead frame surface of the lead frame.

In an advantageous example, either the first semiconductor die surface of the semiconductor die and the second lead frame surface and/or the at least one clip and the second semiconductor die surface of the semiconductor die are soldered to each other.

The disclosure also relates to a method of manufacturing a semiconductor device according to the disclosure. The method is composed of the steps of:
i) providing a composite lead frame comprising a first lead frame surface and a second lead frame surface opposite the first lead frame surface, the composite lead frame being composed of a plurality of die attach paddles arranged in a matrix and provided with one of a first or a second locking means;
ii) mounting, in each die attach paddle, a semiconductor die comprising a first semiconductor die surface and a second semiconductor die surface opposite the first semiconductor die surface, such that the first semiconductor die surface of the semiconductor die is connected to the second lead frame surface;
iii) providing a composite clip frame composed of a plurality of die clip sets arranged in a matrix corresponding with the matrix of the plurality of die attach paddles and provided with the other of the first or the second locking means;
iv) mounting the composite clip frame on the composite lead frame and the matrix of semiconductor dies, such that the first locking means engage with the second locking means and that movement is only possible in only one direction, wherein each die clip set comprises a locking clip and at least one clip, wherein the at least one clip is connected to the second semiconductor die surface of the semiconductor die and wherein the locking clip is part of the first or second locking means and engages the second lead frame surface of the lead frame;
v) encapsulating the composite lead frame, the matrix of the plurality of semiconductor dies and the composite clip frame with a mold compound,
vi) singulating a semiconductor device from the encapsulated matrix of semiconductor dies.

An optional step vii) involves the removal of any exposed frame parts from the composite clip frame.

In a further detail of the method according to the disclosure, the encapsulating step v) is followed by
v-1) a polishing step such that the locking clip and the at least one clip are exposed forming an outer surface of the semiconductor device, and preferably the mold compound and the exposed locking clip and the at least one exposed clip form a single planar surface.

Additionally, the connecting steps i) and ii) comprise the sub-steps of:
viii-1) applying a solder paste between the first semiconductor die surface of the semiconductor die and the second lead frame surface and/or the at least one clip and the second semiconductor die surface of the semiconductor die, and
viii-2) performing soldering.

### BRIEF DESCRIPTION OF THE DRAWINGS

The disclosure will now be discussed with reference to the drawings, which show in:
Figure 1 an exploded view of main components of a semiconductor device,
Figure 2 main components of the assembled semiconductor device,
Figure 3 an enlarged view of locking means,
Figure 4 a cross section of the semiconductor device shown in figure 2,
Figure 5 a first alternative locking means example,
Figure 6 a second alternative locking means example,
Figure 7a-7b a comparison of a clip frame according to the disclosure and a prior art clip frame;
Figure 8a-8i depicting the method steps for manufacturing a semiconductor device according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

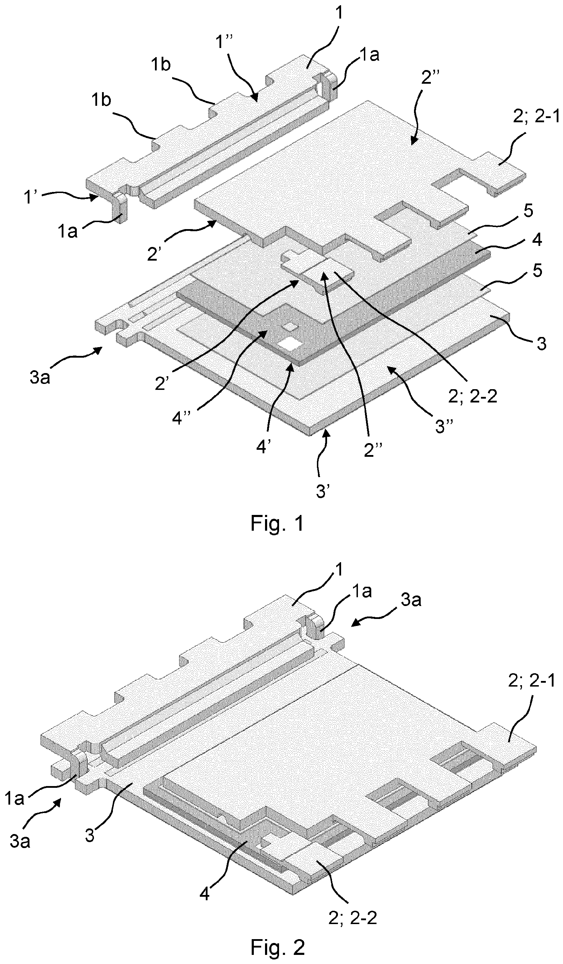

Figure 1 shows an exploded view of the main components of a semiconductor device according to the disclosure. A locking system comprising two parts, namely a locking clip 1 and a lead frame 3. The lead frame 3 comprises a first lead frame surface 3' and a second lead frame surface 3" opposite the first lead frame surface 3'. The locking clip 1 comprises a first locking clip surface 1' and a second locking clip surface 1" opposite the first locking clip surface 1'.

The locking clip 1 comprises a first locking means and the lead frame 3 comprises a second locking means. In this example the first locking means are implemented as a pillar 1a or a protrusion 1a while the second locking means are implemented as a slot 3a or a socket receiver 3a or a recess 3a. However it should be noted that any kind of a slot/socket receiver 3a will be suitable as long as it may engage with the protrusion/pillar 1a.

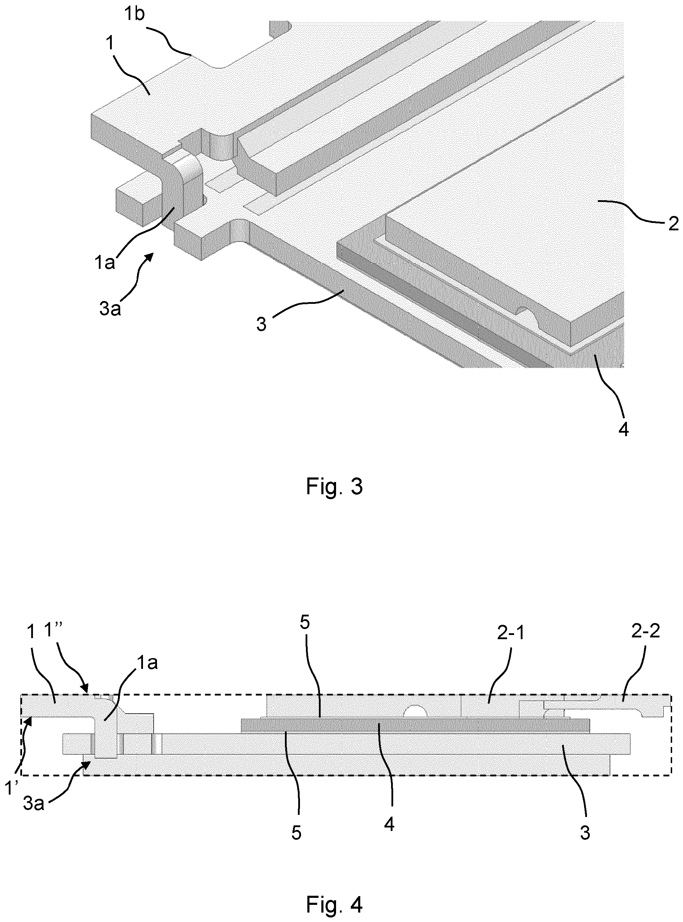

The first locking means are structured to engage with the second locking means, such that a movement between the locking clip 1 and the lead frame 3 is possible in only one direction. In this example it is only possible to move the locking clip 1, while engaged with the lead frame 3, only vertically, that is perpendicular to a plane formed by the lead frame 3, wherein the locking clip 1 composed of the pillars 1a, which are bended approximately 90° towards the lead frame 3 or 3a while the other clip end lends 1b are bended towards the end of the package after singulation, and wherein clip 1 is initially connected and opposite to clip 2 before singulation. A much greater detail is shown in figure 3.

The locking clip 1 is placed on the lead frame 3, such that the first locking clip surface 1' of the locking clip 1 is in contact with the second lead frame surface 3" of the lead frame 3.

In figure 1 a semiconductor die 4 is shown, comprising a first semiconductor die surface 4' and a second semiconductor die surface 4" opposite the first semiconductor die surface 4', and at least one clip 2 comprising a first clip surface 2' and a second clip surface 2" opposite the first clip surface 2'. The first semiconductor die surface 4' of the semiconductor die 4 is connected to the second lead frame surface 3" and wherein the first clip surface 2' of the at least one clip 2 is connected to the second semiconductor die surface 4" of the semiconductor die 4.

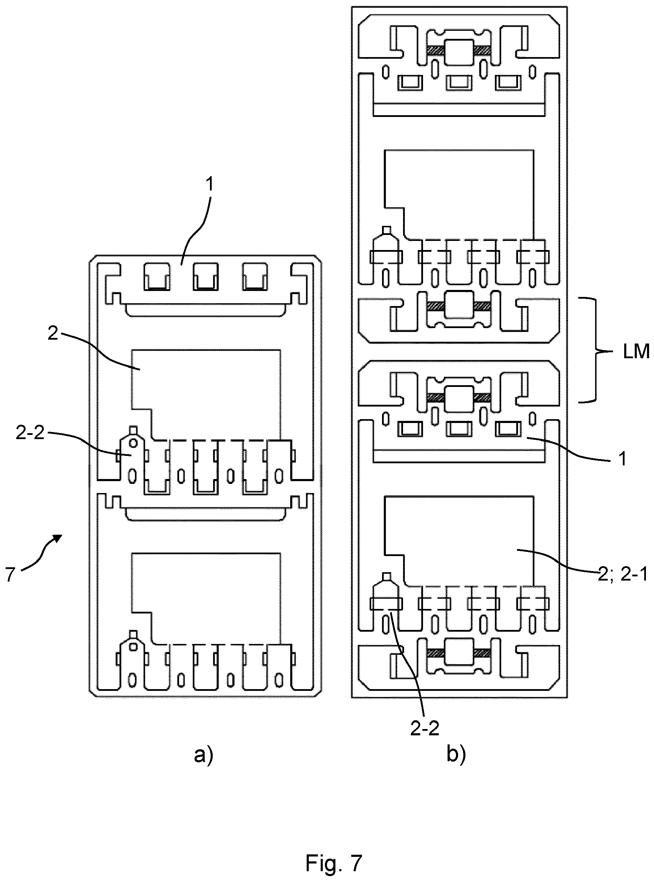

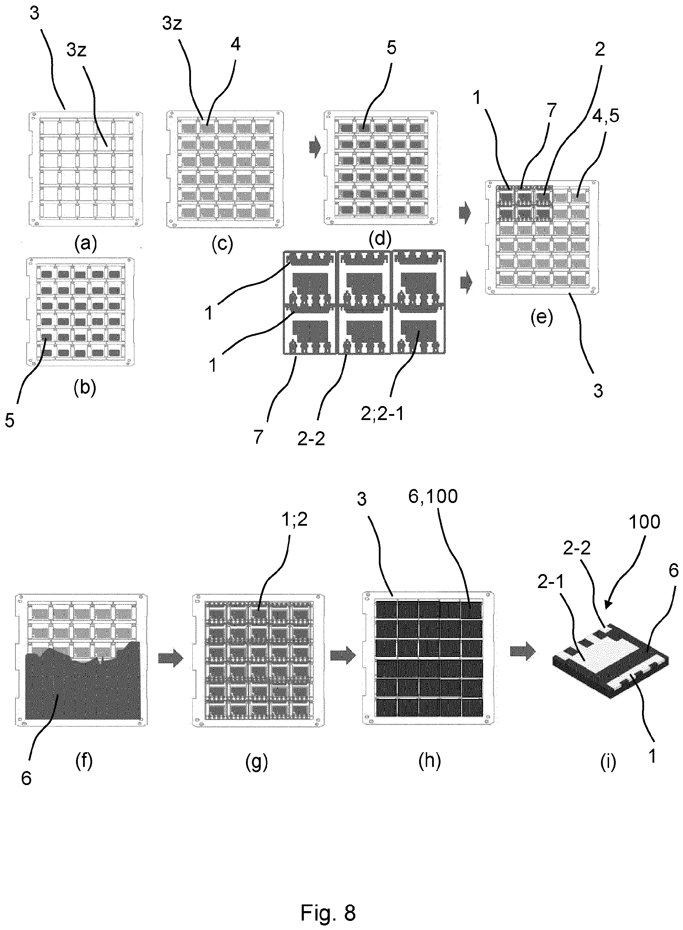

Note, that the locking clip 1 and the at least one clip 2 form a clip set for the associated semiconductor die 4. Each clip set is arranged in a matrix forming a composite clip frame 7 as shown in Figures 7 and 8 which facilitates the manufacturing of such semiconductor device (denoted with reference numeral 100 in e.g. Figure 8i).

Also note, that each clip set may comprise more than one clip 2, for example two clips 2, denoted with reference numeral 2-1 and 2-2. The functionality of the separate clips 2-1 and 2-2 will be clarified when discussing the manufacturing method of the disclosure with reference to Figure 8.

Additionally a solder paste 5 (or any other similar die attach material) is placed between the first semiconductor die surface 4' of the semiconductor die 4 and the second lead frame surface 3" and the at least one clip 2 and the second semiconductor die surface 4" of the semiconductor die 4. However it should be noted that other means for mounting or connecting the semiconductor die 4 on the lead frame 3 and the at least one clip 2 on the die 4 may be used. For example, one of the mentioned connections may be achieved by means of soldering while the other mounting connection is performed using a different technique using any other suitable die attach material. It also should be noted that reference numeral 5 may refer to a solder paste used during manufacturing, but it should be clear that it may also refer to the solder paste after soldering.

Figure 2 (and in more detail in Figure 3) provides the same semiconductor device as in figure 1. In figure 2, and it is shown in an assembled state during a manufacturing process prior to encapsulation. A final product is encapsulated in a mold compound, not shown here, which encapsulates the semiconductor die 4 such that the mold compound forms an outer surface of the semiconductor device with the second locking clip surface 1" of the locking clip 1, the second clip surface 2" of the at least one clip 2 and the first lead frame surface 3' of the lead frame 3.

Figure 4 shows a cross section of the semiconductor device from figure 2, encapsulated with a mold compound, depicted schematically with a dashed line denoted with reference numeral 6.

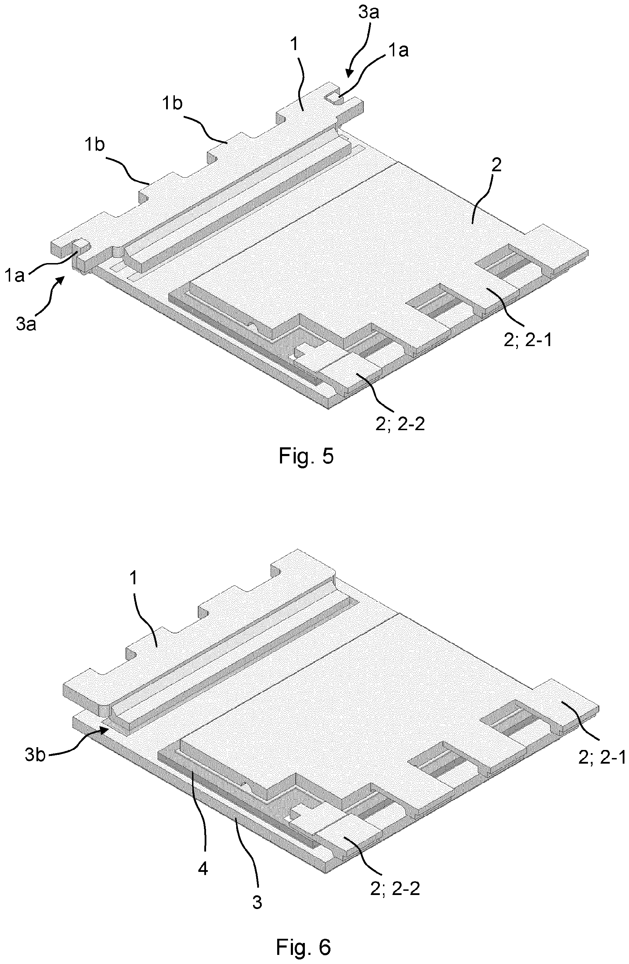

Figure 5 shows another example of implementation of the first locking and the second locking means. In this example the first locking means are implemented as a pillar or protrusion 1a while the second locking means are implemented as a recess or slot/socket 3a, however unlike on figure 1 in here the pillar/protrusion 1a is a part of the lead frame 3 while the slot/socket 3a is a part of the locking clip 1. It should be noted that there may be at one, two or more pillars/protrusions 1a. In shown examples the pillar/protrusion 1a extends approximately perpendicular to a plane formed by the locking clip 1 or the lead frame 3. In shown examples, the pillar/protrusion 1a is made by bending a piece of the locking clip 1 (Figures 1-2-3-4) or the lead frame 3 (Figure 5) however the person skilled in the art will understand that other techniques of manufacturing the pillar/protrusion 1a are quite feasible.

It should be noted that in both examples the slot 3a may be located on the edge or inside of the either lead frame 3 or locking clip 1. It should be noted that it is also possible that the locking clip comprises one pillar/protrusion 1a and one slot 3a while the lead frame 3 comprises corresponding one pillar/protrusion 1a and one slot 3a. The person skilled in the art would know that the goal to achieve is to prevent movement of a clip frame 7, which comprise the locking clip 1 and the clip 2, with respect to the lead frame 3.

Figure 6 shows yet another example of implementation of the first locking and the second locking means. In this example the pillar/protrusion 1a is formed as an elongated ridge, which, after assembling, fits or accommodates in an elongated groove 3b provided in the lead frame 3. Both elongated pillar/protrusion 1a and groove 3b extend over a significant width dimension of the semiconductor device.

Figure 7a shows the clip frame 7 according to the example, whereas figure 7b depicts a version known from the prior art. It should be clear that solution presented in this application needs less space since a locking mechanism LM is no longer present. The locking clip 1 takes a function of the locking mechanism LM which allows to reduce a total surface of the clip frame 7, as well as an amount of excessive material which needs to be removed during the singulation step.

A method of manufacturing a semiconductor device with the locking system as described above is shown in more detailed steps in Figure 8a-8i.

A first step, see Figure 8a, consists of providing a composite lead frame 3. The composite lead frame 3 is preferable of a rectangular shape and comprises a first lead frame surface 3' and a second lead frame surface 3" opposite the first lead frame surface 3'. More importantly, the composite lead frame 3 is composed of a plurality of die attach paddles 3z, which are arranged in a matrix form.

The composite lead frame 3 is provided - at its relevant locations - with one of the first or the second locking means.

In a second method step shown in Figure 8c, in each die attach paddle 3z, a semiconductor die 4 is mounted. As outlined above, when discussing Figures 1-7, each semiconductor die 4 comprises a first semiconductor die surface 4' and a second semiconductor die surface 4" opposite the first semiconductor die surface 4', such that the first semiconductor die surface 4' of the semiconductor die 4 is connected to the second lead frame surface 3".

The mounting or connecting step of each semiconductor die 4 to the lead frame 3 may involve the sub-steps of applying a solder paste 5 between the first semiconductor die surface 4' of the semiconductor die 4 and the second lead frame surface 3" of (the respective die attach paddle 3z) of the lead frame 3, and subsequently soldering the semi-conductor die 4 to the lead frame 3. This sub-step is depicted in Figure 8b and 8c. Of course any other suitable die attach material can be used to perform the mounting or connecting step between the lead frame 3 and the semiconductor dies 4.

In Figure 8d a next method step is shown, involving the provision of a composite clip frame 7. The composite clip frame 7 is composed of a plurality of die clip sets 1-2, which are likewise arranged in a matrix. This matrix corresponds with the matrix of the plurality of die attach paddles 3z of the lead frame 3. Each clip set 1-2 is provided with the other of the first or the second locking means. Here, each clip set is composed of a locking clip 1 and at least one clip 2 for an associated semiconductor die 4 mounted in a respective die attach paddle 3z. Each clip set may comprise more than one clip 2, for example two clips 2, denoted with reference numeral 2-1 and 2-2.

In the method step of Figure 8e, the composite clip frame 7 is mounted on the composite lead frame 3 and the matrix of semiconductor dies 4, such that the matrix of clip sets 1-2 align with the matrix of semiconductor dies 4, and the first locking means engage with the second locking means. Accordingly, movement of the composite clip frame 7 relative to the composite lead frame 3 and the matrix of semiconductor dies 4 is only possible in only one direction.

The mounting or connecting step of the composite clip frame 7 on the composite lead frame 3 and the matrix of semiconductor dies 4 may involve the sub-steps of applying a solder paste 5 between each at least one clip 2; 2-1,2-2 and the second semiconductor die surface 4" of the associated semiconductor die 4in the matrix, and subsequently soldering the composite clip frame 7 to the matrix of semiconductor dies 4. This sub-step is depicted in Figure 8d and 8e. Of course any other suitable die attach material can be used to perform the mounting or connecting step between the clip frame 7 and the semiconductor dies 4.

The composite lead frame 3 is provided - at its relevant locations - with one of the first or the second locking means, whereas the composite clip frame 7 is likewise - at its relevant locations - provided with the other one of the first or second locking means. In this example shown in Figure 8a-8i, the composite lead frame 3 is provided with multiple slots / socket receivers 3a, and the locking clip 1 of the composite clip frame 7 is provided with protrusions/pillars 1a, re. the example of Figures 1-4.

Alternatively the composite lead frame 3 may be provided with multiple pillars / protrusions 1a, and the locking clip 1 of the composite clip frame 7 has corresponding slots / socket receivers 3a, re. the example of Figure 5.

Each die clip set comprises a locking clip 1 which will be connected with the drain terminal of the lead frame 3, whereas clips 2-1 and 2-2 are connected to the second semiconductor die surface 4" of the semiconductor die 4, in particular the with the source and the gate terminal, thereof. The locking clip 1 is part of one of the locking means and engages other one of the locking means present in the lead frame 3.

In a next step, Figure 8f, the composite lead frame 3, the matrix of the plurality of semiconductor dies 4 and the composite clip frame 7 are encapsulated with a mold compound 6.

A semiconductor device 100 (see Figure 8h and 8i) is being singulated in a next method step from the encapsulated matrix of semiconductor dies 4 and alternatively, an optional step involves the removal of any exposed frame parts from the composite clip frame 7, either before or after the singulating step.

Alternatively, a polishing step may be performed prior to the singulation step, as shown in Figure 8g, wherein the locking clip 1 and the at least one clip 2 are exposed forming an outer surface of the semiconductor device 100 after singulation. Preferably the polishing step results in that the semiconductor device 100 has a single planar surface composed of the mold compound 6, the exposed locking clip 1 and the at least one exposed clip 2.

The benefits of the method for manufacturing a plurality of semiconductor devices 100, wherein the lead frame and the several clips are effectively aligned with the use of a clip flame composed of a matrix of multiple clip sets, which each clips set intended for a semiconductor die 4 positioned at a die attach paddle 3z of the composite lead frame 3.

In one of the depicted example, each individual clip set of the matrix of clip sets consists of a plurality of pillars or protrusions, which are bended at an 90° angle relative to the plane of the composite lead frame 3 (plane of the composite clip frame 7) and engage with slots or recesses present in the lead frame 3. Each clip set are part of a set of first drain terminals and a set of source and gate clip leads.

The source and gate clips provided with the pillars 1a are initially connected with the first drain clip and the pillars 1a, connected in between the source, the gate and the first drain terminals, are inserted in between corresponding slots / socket receivers / recesses 3a present on the lead frame 3, which slots / socket receivers / recesses 3a are positioned at the sides of each individual die attach paddle 3z. Accordingly, each clip set 1, 2 is properly aligned with their corresponding semiconductor die 4 mounted in the associated die attach paddle 3z of the composite lead frame 3.

The efficiency of the manufacturing method according to the disclosure lies in the fact that each individual die attach paddle 3z is arranged in a matrix forming a composite lead frame 3, and likewise each clip set is arranged in a corresponding matrix forming the composite clip frame 7. Both matrixes of the leaf frame and the clip frame are integrated together during the die/clip attach process and properly aligned by means of the engaging locking mechanisms.

A further efficiency lies in the fact, that the assembled die 4, the clip frame 7 and the lead frame 3 undergo successive process steps, such as molding, PMC, terminal polishing, plating, and package saw singulation, making the 1st drain terminal attached to the main drain terminal.

Moreover, when the individual semiconductor devices 100 are being singulated during the package saw singulation step, the first drain terminal (being formed by the locking clip 1) will be separated from the source and clip terminals (being formed by the clips 2-1 and 2-2), creating individual products.

Moreover, after the singulation step, the singulated drain clip 1 having the pillars 1a being bend at a 90° angle and inserted and electrically attached to the corresponding die attach paddle 3z by means of tie bars, will form a singulated drain terminal with its sawn free tip being exposed to the external side of the encapsulating mold 6 of the semiconductor package 100

### LIST OF REFERENCE NUMERALS USED

- 1: locking clip
- 1': first locking clip surface
- 1": second locking clip surface
- 1a: pillar / protrusion / bar
- 1b: clip end leads
- 2 (2-1, 2-2): clip
- 2': first clip surface
- 2": second clip surface
- 3: lead frame
- 3a: slot / socket receiver / recess
- 3b: groove
- 3z: die attach paddle
- 3': first lead frame surface
- 3": second lead frame surface
- 4: semiconductor die
- 4': first semiconductor die surface
- 4": second semiconductor die surface
- 5: solder paste
- 6: mould compound
- 7: composite clip frame
- LM: locking mechanism
- 100: semiconductor device (singulated)

## Claims

1. A locking system for a semiconductor device comprising a locking clip and a lead frame, wherein the lead frame comprises a first lead frame surface and a second lead frame surface opposite the first lead frame surface, and wherein the locking clip comprises a first locking clip surface and a second locking clip surface opposite the first locking clip surface,
wherein the locking clip comprises a first locking means and wherein the lead frame comprises a second locking means,
wherein the first locking means are structured to align with the second locking means, such that a movement of the locking clip relative to the lead frame is possible in only one direction, and wherein the locking clip is placed on the lead frame, such that the first locking clip surface of the locking clip is in contact with the second lead frame surface of the lead frame.

2. The locking mechanism according to claim 1, wherein the movement is only possible in a direction perpendicular to the plane formed by the lead frame.

3. The locking mechanism according to claim 1 or 2, wherein one of the first locking means or the second locking means is formed as at least one protrusion, preferably two protrusions and where the other one of the first locking means or the second locking means is formed as a corresponding socket receiver.

4. The locking mechanism according to claim 3, wherein the socket receiver is in form of a slot.

5. The locking mechanism according to claim 4, wherein the slot is located on an outer edge of the locking clip or the lead frame.

6. The locking mechanism according to claim 3, wherein the socket receiver is in form of a groove.

7. The locking mechanism according to anyone of claims 3-6, wherein the pillar extends approximately perpendicular to a plane formed by the locking clip or the lead frame.

8. A semiconductor device comprising
a locking system according to anyone of the claims 1-7,
a semiconductor die comprising a first semiconductor die surface and a second semiconductor die surface opposite the first semiconductor die surface,
at least one clip comprising a first clip surface and a second clip surface opposite the first clip surface, and
mold compound,
wherein the first semiconductor die surface of the semiconductor die is connected to the second lead frame surface and wherein the first clip surface of the at least one clip is connected to the second semiconductor die surface of the semiconductor die,
wherein the mold compound encapsulates the semiconductor die such that the mold compound forms an outer surface of the semiconductor device with the second locking clip surface of the locking clip, the second clip surface of the at least one clip and the first lead frame surface of the lead frame.

9. The semiconductor device according to claim 8, wherein either the first semiconductor die surface of the semiconductor die and the second lead frame surface and/or the at least one clip and the second semiconductor die surface of the semiconductor die are soldered to each other.

10. A method of manufacturing a semiconductor device according to claim 8 or 9, comprising steps of:
i) providing a composite lead frame comprising a first lead frame surface and a second lead frame surface opposite the first lead frame surface, the composite lead frame being composed of a plurality of die attach paddles arranged in a matrix and provided with one of a first or a second locking means;
ii) mounting, in each die attach paddle, a semiconductor die comprising a first semiconductor die surface and a second semiconductor die surface opposite the first semiconductor die surface, such that the first semiconductor die surface of the semiconductor die is connected to the second lead frame surface;
iii) providing a composite clip frame composed of a plurality of die clip sets arranged in a matrix corresponding with the matrix of the plurality of die attach paddles and provided with the other of the first or the second locking means;
iv) mounting the composite clip frame on the composite lead frame and the matrix of semiconductor dies, such that the first locking means engage with the second locking means and that movement is only possible in only one direction, wherein each die clip set comprises a locking clip and at least one clip, wherein the at least one clip is connected to the second semiconductor die surface of the semiconductor die and wherein the locking clip is part of the first or second locking means and engages the second lead frame surface of the lead frame;
v) encapsulating the composite lead frame, the matrix of the plurality of semiconductor dies and the composite clip frame with a mold compound,
vi) singulating a semiconductor device from the encapsulated matrix of semiconductor dies.
vii) removing the frame of the clip frame.

11. The method according to claim 10, wherein the encapsulating step v) is followed by
v-1) a polishing step such that the locking clip and the at least one clip are exposed forming an outer surface of the semiconductor device, and preferably the mold compound and the exposed locking clip and the at least one exposed clip form a single planar surface.

12. The method according to claim 10 or 11, wherein the connecting steps ii) and iv) comprise the sub-steps of:
viii-1) applying a solder paste between the first semiconductor die surface of the semiconductor die and the second lead frame surface and/or the at least one clip (2) and the second semiconductor die surface of the semiconductor die, and
viii-2) performing soldering.
